# EUROPÄISCHE PATENTSCHRIFT

(11) **EP 3 603 358 B1**
(45) Veröffentlichungstag und Bekanntmachung des Hinweises auf die Patenterteilung: **23.10.2024**
(21) Anmeldenummer: 18714468.8
(22) Anmeldetag: 21.03.2018
(51) Int. Cl.: H05K 5/00, G01L 19/14

(54) **STEUERGERÄT FÜR EIN FAHRZEUG MIT WENIGSTENS EINEM DRUCKSENSORELEMENT**
CONTROLLER FOR A VEHICLE COMPRISING AT LEAST ONE PRESSURE SENSOR ELEMENT
APPAREIL DE COMMANDE POUR UN VÉHICULE COMPRENANT AU MOINS UN ÉLÉMENT CAPTEUR DE PRESSION

(30) Priorität: 27.03.2017 DE 102017106553
(43) Veröffentlichungstag der Anmeldung: 05.02.2020
(73) Patentinhaber: KNORR-BREMSE Systeme für Nutzfahrzeuge GmbH, 80809 München (DE)
(72) Erfinder: HUBER, Christian, 80937 München (DE); LECHNER, Klaus, 91362 Pretzfeld (DE); RÖTHER, Friedbert, 74389 Cleebronn (DE); POHLEY, Karin, 90489 Nürnberg (DE); MLYNARSKI, Amadeus, 81371 München (DE); NIEDERMEIER, Stefan, 94542 Haarbach (DE)
(74) Vertreter: Wiedemann, Markus
(86) Internationale Anmeldenummer: PCT/EP2018/057129
(87) Internationale Veröffentlichungsnummer: WO 2018/177833

(56) Entgegenhaltungen:
- EP-A2- 1 152 231
- DE-A1- 102009 026 444
- DE-A1- 102010 029 868
- DE-A1- 102010 043 393
- DE-T2- 69 309 173

## Beschreibung

Die Erfindung betrifft eine elektro-pneumatische Bremseinrichtung für ein Fahrzeug beinhaltend wenigstens ein elektronisches Steuergerät mit wenigstens einem Drucksensorelement gemäß Anspruch 1.

Aus dem Stand der Technik sind Steuergeräte mit Drucksensoren in Gehäusen mit separatem pneumatischem Anschluss bekannt, die eine Leiterplatte des Steuergeräts elektrisch kontaktieren, z.B. durch Lötung, Schweißung, gebondet, oder gesteckt und mittels eines separaten Druckführungselement mit druckführenden Bauteilen verbunden sind. Die Abdichtung erfolgt dann am Drucksensorgehäuse an dem separaten Druckführungselement. Der Toleranzausgleich erfolgt dann über das separate Druckführungselement, z.B. ein Druckrohr.

EP 1 152 231 A2 offenbart ein elektronisches Steuergerät mit einem Gehäuse, einem Deckel und mindestens einer im Deckel angeordneten Leiterplatte, die mit elektronischen Bauelementen bestückt ist, von welchen mindestens eines ein Drucksensor ist, wobei zur Druckzufuhr zum Drucksensor ein am Gehäuse befestigter Schnorchel vorgesehen ist, welcher beim Zusammenfügen von Gehäuse und Deckel mit seinem oberen Teil den Drucksensor umschließt und dessen Rand gegen die Leiterplatte abdichtet. Das Gehäuse verfügt über einen Druckraum mit dem zu messenden Druck, wobei der Druckraum über den Schnorchel mit dem Drucksensor verbunden ist und in welchem ein Ventil angeordnet ist.

DE 10 2009 026 444 A1 offenbart ein Steuergerät, insbesondere für ein Kraftfahrzeug, mit einem mehrteiligen Gehäuse, in dem zumindest eine Leiterplatte angeordnet ist, wobei zumindest ein Gehäuseteil des Gehäuses einen Luftkanal aufweist, der von einer Öffnung in dem Gehäuseteil zu einem auf der Leiterplatte angeordneten, den Umgebungsdruck ermittelnden Drucksensor führt und gegen die Leiterplatte abgedichtet ist. DE 10 2010 029868 A1 offenbart eine Getriebesteuerung mit einer Trägerplatte sowie einem auf der Trägerplatte aufgenommenen Schaltungsträger, an welchem zumindest Teile einer Getriebesteuerelektronik ausgebildet sind, wobei die Getriebesteuerung ferner einen Drucksensor mit einem Aufnehmer aufweist, insbesondere einen MEMS-Drucksensor, wobei der Drucksensor ohne eigenes Trägergehäuseteil mittels eines in einer Durchgangsöffnung der Trägerplatte fixierten Abstützelements an der Trägerplatte dauerhaft angeordnet ist. DE 10 2010 043393A1 offenbart einen piezoresistiven Drucksensor, wobei der Sensor und eine Auswerteelektronik in einem druckbeaufschlagten Bereich nebeneinander angeordnet sind. Eine gattungsgemäße elektro-pneumatische Bremseinrichtung wird in DE 69309173 T2 offenbart.

Der Erfindung liegt die Aufgabe zugrunde, eine elektro-pneumatische Bremseinrichtung derart weiterzubilden, dass sie in ihren Funktionen zuverlässiger und einfacher herstellbar ist.

Diese Aufgabe wird erfindungsgemäß durch die Merkmale von Anspruch 1 gelöst.

### Offenbarung der Erfindung

Die Erfindung schlägt eine elektro-pneumatische Bremseinrichtung für ein Fahrzeug vor, beinhaltend wenigstens ein elektronisches Steuergerät mit wenigstens einem Drucksensorelement und einem Gehäuse mit einer Druckführung, durch welche das Drucksensorelement mit einem Druckmedium druckbeaufschlagt ist, sowie mit einer Auswerteeinheit, welche ein von dem vom Drucksensorelement erfassten Druck in der Druckführung abhängiges Drucksignal erzeugt, sowie mit einem Schaltungsträger, auf welchem zumindest ein Teil einer Steuerelektronik des Steuergeräts angeordnet ist, wobei das Drucksignal der Auswerteeinheit in die Steuerelektronik eingesteuert wird, wobei
a) die Druckführung den Schaltungsträger zumindest teilweise direkt kontaktiert und im Kontaktbereich der Druckführung mit dem Schaltungsträger Dichtungsmittel angeordnet sind, welche einen durch das Druckmedium druckbeaufschlagten Bereich der Druckführung gegenüber der Umgebung abdichten, und dass
b) das Drucksensorelement direkt auf dem Schaltungsträger und auf diesem zudem derart angeordnet ist, dass das Drucksensorelement in dem mit dem Druckmedium druckbeaufschlagten Bereich der Druckführung angeordnet ist, und dass
c) die Auswerteeinheit mit dem Schaltungsträger elektrisch direkt verbunden ist, wobei die Auswerteeinheit wenigstens eine elektrische Kontaktfläche aufweist, welche den Schaltungsträger direkt kontaktiert, wobei die elektrische Kontaktfläche der Auswerteeinheit auf den Schaltungsträger gebondet oder gelötet ist und wobei
d) die elektro-pneumatische Bremseinrichtung eine Magnetventileinrichtung beinhaltet, wobei das elektronische Steuergerät abhängig von dem Drucksignal der Auswerteeinheit die Magnetventileinrichtung elektrisch steuert, und wobei
e) das Gehäuse des Steuergeräts mit einem Ventilblock der Magnetventileinrichtung verbunden ist, und wobei
f) die Druckführung an wenigstens einen Einlass oder einen Auslass wenigstens eines Ventils der Magnetventileinrichtung angeschlossen ist, wobei
g) die Dichtungsmittel eine in einer Ausnehmung in einer zum Schaltungsträger weisenden Oberfläche der Druckführung gehaltene, elastische Formdichtung beinhalten, welche gegen eine gegenüberliegende Oberfläche des Schaltungsträger vorgespannt ist, wobei die zum Schaltungsträger weisende Oberfläche der Druckführung eine Stirnfläche der Druckführung ist, und wobei
h) die zum Schaltungsträger weisende Oberfläche der Druckführung zugleich eine Flanschfläche eines an der Durchführung endseitig angeordneten planen Flansches bildet, wobei der plane Flansch an dem planen Schaltungsträger lösbar befestigt ist.

Unter einer "direkten Kontaktierung" der Druckführung mit dem Schaltungsträger ist daher zu verstehen, dass lediglich noch die Dichtmittel zwischen der Druckführung und dem Schaltungsträger angeordnet sein können.

Unter einer "elektrisch direkten Verbindung" zwischen der Auswerteeinheit und dem Schaltungsträger ist zu verstehen, dass diese elektrische Verbindung ohne weitere Verbindungsmittel wie beispielsweise Kontaktfüßchen bewerkstelligt wird.

Der Schaltungsträger ist bevorzugt als Leiterplatte ausgebildet und beinhaltet neben der Steuerelektronik oder Teilen davon beispielsweise auch Endstufen.

Mit den oben beschriebenen Maßnahmen kann ein separates Druckführungselement entfallen, wodurch Dichtflächen und auch die Montage des Druckführungselements eingespart werden kann. Weiterhin ergibt sich eine verkleinerte Bauform durch den dann möglichen Entfall des Gehäuses des Drucksensors und des pneumatischen Anschlusses. Weiterhin ist durch die direkte pneumatische Kontaktierung des Drucksensors und der direkten Dichtung der Druckführung auf der Leiterplatte auch kein Toleranzausgleich mehr notwendig.

Die Erfindung betrifft daher eine elektro-pneumatische Bremseinrichtung als druckmittelbetriebene Einrichtung, beinhaltend wenigstens ein elektronisches Steuergerät. Die elektro-pneumatische Bremseinrichtung beinhaltet dann eine Magnetventileinrichtung, die in einem Ventilblock realisiert ist, wobei die Magnetventileinrichtung wenigstens ein Magnetventil oder Ventil (z.B. Relaisventil) mit wenigstens einem Einlass und wenigstens einem Auslass umfasst. Das elektronische Steuergerät steuert dann abhängig von dem Drucksignal der Auswerteeinrichtung die Magnetventileinrichtung der elektro-pneumatischen Bremseinrichtung elektrisch. Das Drucksignal kann beispielsweise einen von der Magnetventileinrichtung ausgesteuerten Ist-Bremsdruck repräsentieren, welcher dann im Rahmen einer in dem Steuergerät implementierten Bremsdruckregelung beispielsweise auf einen Soll-Bremsdruck geregelt wird. Die Magnetventileinrichtung und das Steuergerät sind dann beispielsweise in einem elektro-pneumatischen Druckregelmodul integriert.

Das Gehäuse des Steuergeräts ist dann mit dem Ventilblock der Magnetventileinrichtung verbunden und die Druckführung an wenigstens einen Einlass oder einen Auslass wenigstens eines Ventils (z.B. Relaisventil) oder Magnetventils der Magnetventileinrichtung angeschlossen.

Durch die in den Unteransprüchen aufgeführten Maßnahmen sind vorteilhafte Weiterbildungen und Verbesserungen der in Anspruch 1 angegebenen Erfindung möglich.

Besonders bevorzugt kontaktiert eine Platine der Auswerteeinheit den Schaltungsträger direkt.

Gemäß einer Weiterbildung kann die Auswerteeinheit durch wenigstens einen ASIC gebildet werden. Bei einem ASIC handelt es sich um eine anwendungsspezifische integrierte Schaltung (Application-Specific Integrated Circuit) als elektronische Schaltung, die als integrierter Schaltkreis realisiert ist. Die Funktion eines ASICs ist damit nicht mehr veränderbar. Vorzugsweise kommt ein rein digitaler ASIC zum Einsatz, der eine große Zahl von Logikfunktionen integriert, die sonst aus diversen Standardbausteinen wie Prozessor, Logikfamilien oder ähnlichen Bausteinen zusammengestellt werden müssten. Alternativ kann ein Mixed-Signal-ASIC zum Einsatz kommen, der aus digitalen und analogen Funktionen besteht. Dabei ist dann eine analoge Schaltung wie z. B. ein Analog-Digital-Wandler vorhanden.

Gemäß einer Variante können die Auswerteeinheit und das wenigstens eine Drucksensorelement auf verschiedenen Seitenflächen des Schaltungsträgers angeordnet sein.

Gemäß einer weiteren Variante können die Auswerteeinheit und das wenigstens eine Drucksensorelement auch eine Baueinheit bilden. Diese Baueinheit kann dann auf einem separaten Träger, z.B. einer Keramikplatte oder einem FR4, oder in einem eigenen Gehäuse angeordnet sein.

Zusätzlich können die Dichtungsmittel wenigstens eine Klebung zwischen einer Oberfläche der Druckführung und einer Oberfläche des Schaltungsträgers beinhalten. In diesem Fall dient der Klebstoff neben seiner Funktion als den Stoffschluss zwischen Druckführung und Schaltungsträger erzeugendes Mittel zugleich als Dichtungsmittel.

Die Druckführung kann insbesondere rohrförmig sein. Dabei kann insbesondere eine Stirnfläche einer rohrförmigen Druckführung eine Fläche des Schaltungsträgers direkt kontaktieren. In diesem Fall bildet dann der Schaltungsträger einen Boden der Druckführung aus. Insbesondere ist eine Mittel- oder Längsachse der Druckführung senkrecht zu dem Schaltungsträger angeordnet.

Insbesondere ist auch die von der Druckführung kontaktierte Oberfläche des Schaltungsträgers insbesondere hinsichtlich ihrer Geometrie (Planheit) und Oberflächenstruktur ausgebildet, dass sie eine dichtende Funktion hat. Zur Schaffung einer geeigneten Oberflächenstruktur auf dem Schaltungsträger, der beispielsweise als Leiterplatte ausgebildet ist, können beispielsweise die Leiterbahnen entflechtet und die Durchkontaktierung abgedichtet werden. Auch kann ein in der Regel auf dem Schaltungsträger ohnehin vorhandener Lötstopplack eine Dichtfläche gegenüber der Druckführung bilden.

Empfindliche Bereiche wie die elektrische Kontaktierung des Drucksensorelements und/oder der Auswerteeinheit auf dem Schaltungsträger können durch Gel, Lack, etc. geschützt werden.

Auch können mehrere Drucksensorelemente und Auswerteeinheiten in einem Array (Feld) auf dem Schaltungsträger vorgesehen werden, wobei die pneumatische Kontaktierung zu der Druckführung dann beispielsweise über mehrere Druckkanäle unter Verwendung von einem oder mehreren Dichtelementen (O-Ring, Formdichtung, Klebung, eingespritzte Dichtung) erfolgen kann.

Der Schaltungsträger und dessen direkte pneumatische Kontaktierung mit der Druckführung können direkt auf oder in einem Magnetventil oder auf oder in einem Ventilblock angeordnet sein.

Alternativ kann auch wenigstens ein zusätzliches druckführendes Bauteil oder ein Kanal vorgesehen werden, welches das Magnetventil oder den Ventilblock mit der Druckführung pneumatisch verbindet.

Eine Kalibrierung der Auswerteeinheit des wenigstens einen Drucksensorelements kann dann nach der Montage auf dem Schaltungsträger erfolgen, um Einflüsse durch mechanische Verspannungen auf das Drucksignal der Auswerteeinheit zu reduzieren.

Weiterhin kann auch der Schaltungsträger, beispielsweise eine Leiterplatte an dem Gehäuse befestigt sein.

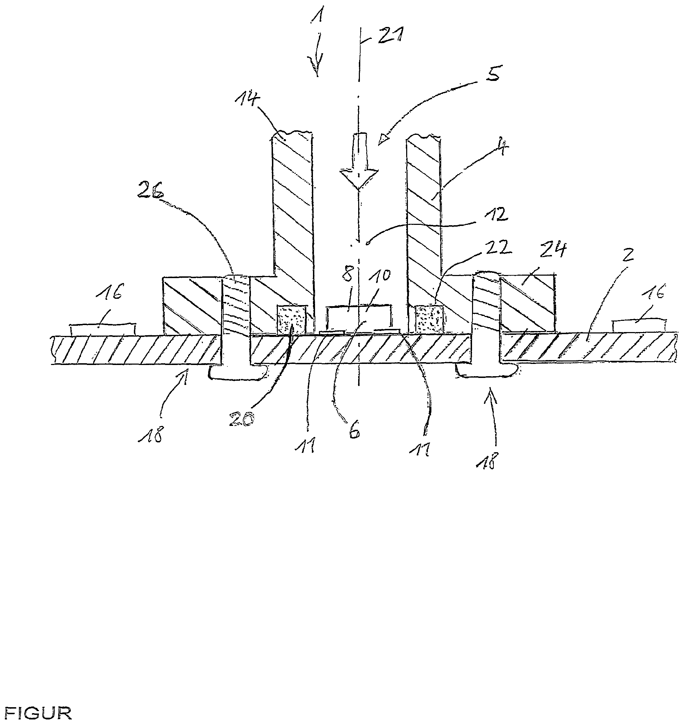

Weitere die Erfindung verbessernde Maßnahmen werden nachstehend gemeinsam mit der Beschreibung eines Ausführungsbeispiels der Erfindung anhand der Zeichnung näher dargestellt.

In der ein Ausführungsbeispiel der Erfindung darstellenden Zeichnung zeigt die einzige Figur eine Querschnittsdarstellung eines Steuergeräts einer elektro-pneumatischen Bremseinrichtung gemäß einer bevorzugten Ausführungsform der Erfindung.

### Beschreibung des Ausführungsbeispiels

In der Figur ist als bevorzugte Ausführungsform eines elektronischen Steuergeräts ein Steuergerät 1 einer elektro-pneumatischen Bremseinrichtung gezeigt. Aus Maßstabsgründen sind von dem Steuergerät 1 hier lediglich ein Schaltungsträger 2, beispielsweise eine Leiterplatte und eine Druckführung 4 sowie eine Baueinheit 6 aus einem Drucksensorelement 8 und einer zugeordneten Auswerteeinheit 10 gezeigt.

Die Druckführung 4 ist hier beispielsweise rohrförmig ausgebildet und weist einen hier inneren, durch ein Druckmedium 5, hier bevorzugt mit Druckluft druckbeaufschlagten Bereich 12 auf. Die Druckführung 4 ist bevorzugt ein Bestandteil eines Gehäuses 14 des Steuergeräts 1. Das Gehäuse 14 ist beispielsweise direkt an einem hier nicht gezeigten Ventilblock oder an einem hier nicht gezeigten Magnetventil einer Magnetventileinrichtung der elektro-pneumatischen Bremseinrichtung befestigt, wobei das Steuergerät 1 die Magnetventile der Magnetventileinrichtung steuert.

Beispielsweise ist die Druckführung 4 mit einem Einlass oder Auslass wenigstens eines Magnetventils oder Ventils (z.B. Relaisventil) der Magnetventileinrichtung pneumatisch verbunden, wobei dann in dem druckbeaufschlagten, hier inneren Bereich 12 der Druckführung 4 dann der pneumatische Druck ansteht, der an diesem Einlass oder Auslass herrscht.

Die Auswerteeinheit erzeugt ein von dem vom Drucksensorelement erfassten Druck in der Druckführung abhängiges elektrisches Drucksignal, welches analog oder bereits digital sein kann. Das Drucksignal wird dann in eine Steuerelektronik 16 auf dem Schaltungsträger 2 des Steuergeräts 1 eingesteuert und dort verarbeitet. Die Steuerelektronik 16 steuert dann (auch) abhängig von dem Drucksignal der Auswerteeinheit 10 des Drucksensorelements 8 die Magnetventile der Magnetventileinrichtung an. Der Schaltungsträger 2 beinhaltet neben der Steuerelektronik 16 mit Controllern oder Teilen der Steuerelektronik 16 auch die Endstufen für die Magnetventile.

Wie aus der Figur hervorgeht, kontaktiert die Druckführung 4 den Schaltungsträger 2 direkt. Weiterhin sind im Kontaktbereich 18 zwischen der Druckführung 4 und dem Schaltungsträger 2 Dichtungsmittel 20 angeordnet, welche den durch das Druckmedium 5 druckbeaufschlagten, hier inneren Bereich 12 der Druckführung 4 gegenüber der Umgebung abdichten, welche hier durch das weitere Innere des Steuergeräts 1 gebildet wird.

Weiterhin ist das Drucksensorelement 8 direkt auf dem Schaltungsträger 2 und auf diesem zudem derart angeordnet ist, dass das Drucksensorelement 8 in dem mit dem Druckmedium 5 druckbeaufschlagten Bereich 12 der Druckführung 4 angeordnet ist. Hier bildet der Schaltungsträger 2 bevorzugt einen Boden der Druckführung 4 aus, an dem das Drucksensorelement 8 angeordnet ist. Weiterhin ist die Auswerteeinheit 10 direkt, d.h. ohne Zwischenelemente wie etwa Kontaktfüßchen mit dem Schaltungsträger 2 elektrisch verbunden.

Gemäß der hier beschriebenen bevorzugten Ausführungsform bilden die Auswerteeinheit 10 und das Drucksensorelement 8 eine Baueinheit 6. Diese Baueinheit 6 ist hier beispielsweise in einem eigenen Gehäuse angeordnet. Dabei kontaktiert eine Platine der Auswerteeinheit 10 den Schaltungsträger 2 direkt, beispielsweise dadurch, dass die Auswerteeinheit 10 bzw. deren Platine wenigstens eine elektrische Kontaktfläche 11 am Gehäuse der Baueinheit 6 aufweist, welche den Schaltungsträger 2 direkt kontaktiert. Dabei ist die elektrische Kontaktfläche 11 der Auswerteeinheit 10 auf den Schaltungsträger 2 gebondet oder gelötet. Die Auswerteeinheit 10 wird beispielsweise durch wenigstens einen ASIC gebildet.

Gemäß einer alternativen, hier nicht gezeigten Ausführungsform können die Auswerteeinheit 10 und das Drucksensorelement 8 auch nicht in einer Baueinheit sondern separat auf verschiedenen, und insbesondere voneinander weg weisenden Seitenflächen des Schaltungsträgers 2 angeordnet sein.

Bevorzugt, wie hier gezeigt, können die Dichtungsmittel 20 eine in einer Ausnehmung, z.B. Nut 22 in einer zum Schaltungsträger 2 weisenden Oberfläche der Druckführung 4 gehaltene, elastische Formdichtung beinhalten, hier beispielsweise einen O-Ring, welcher gegen eine gegenüber liegende Oberfläche des Schaltungsträgers 2 vorgespannt ist. Der O-Ring ist hier daher bevorzugt in der Nut 22 in der zum Schaltungsträger weisenden Stirnfläche der Durchführung 4 gehalten, welche zugleich eine Flanschfläche eines an der Durchführung 4 endseitig angeordneten Flansches 24 bildet. Der plane Flansch 24 ist dann hier bevorzugt lösbar an dem ebenfalls planen Schaltungsträger 2 befestigt, beispielsweise mittels einer Schraubverbindung 26, wobei die Zugkraft der Schrauben dann den O-Ring 20 komprimiert und die Dichtwirkung hervorruft. Daher kontaktiert hier eine plane Stirnfläche der Druckführung 4 eine plane Oberfläche des Schaltungsträgers 2 direkt und/oder über die Dichtungsmittel 20. Insbesondere ist eine Mittel- oder Längsachse 21 der Druckführung 4 senkrecht zu dem Schaltungsträger 2 angeordnet.

Alternativ oder zusätzlich können die Dichtungsmittel wenigstens eine Klebung zwischen einer Oberfläche der Druckführung 4 und einer Oberfläche des Schaltungsträgers 2 beinhalten. In diesem Fall dient der Klebstoff zugleich als Dichtungsmittel 20. Die Druckführung 4 ist dann mit dem Schaltungsträger 2 durch Stoffschluss unlösbar verbunden.

Insbesondere ist die von der Druckführung 4 kontaktierte Oberfläche des Schaltungsträgers 2 insbesondere hinsichtlich ihrer Geometrie (Rauheit, Planheit) und Oberflächenstruktur ausgebildet, dass sie (auch) eine dichtende Funktion hat. Auch kann ein in der Regel auf dem Schaltungsträger 2 vorhandener Lötstopplack als Dichtfläche gegenüber der Stirnfläche der Druckführung 4 verwendet werden.

### Bezugszeichenliste

- 1: Steuergerät
- 2: Schaltungsträger
- 4: Druckführung
- 5: Druckmedium
- 6: Baueinheit
- 8: Drucksensorelement
- 10: Auswerteeinheit
- 11: Kontaktfläche
- 12: druckbeaufschlagter Bereich
- 14: Gehäuse
- 16: Steuerelektronik
- 18: Kontaktbereich
- 20: Dichtungsmittel
- 21: Mittelachse
- 22: Nut
- 24: Flansch
- 25: Dichtungsmittel
- 26: Schraubverbindung

## Patentansprüche

1. Elektro-pneumatische Bremseinrichtung für ein Fahrzeug, beinhaltend wenigstens ein elektronisches Steuergerät (1) mit wenigstens einem Drucksensorelement (8) und einem Gehäuse (14) mit einer Druckführung (4), durch welche das Drucksensorelement (8) mit einem Druckmedium (5) druckbeaufschlagt ist, sowie mit einer Auswerteeinheit (10), welche ein von dem vom Drucksensorelement (8) erfassten Druck in der Druckführung (4) abhängiges Drucksignal erzeugt, sowie mit einem planen Schaltungsträger (2), auf welchem zumindest ein Teil einer Steuerelektronik (16) des Steuergeräts (1) angeordnet ist, wobei das Drucksignal der Auswerteeinheit (10) in die Steuerelektronik (16) eingesteuert wird, wobei
a) die Druckführung (4) den Schaltungsträger (2) zumindest teilweise direkt kontaktiert und im Kontaktbereich (18) der Druckführung (4) mit dem Schaltungsträger (2) Dichtungsmittel (20) angeordnet sind, welche einen durch das Druckmedium (5) druckbeaufschlagten Bereich (12) der Druckführung (4) gegenüber der Umgebung abdichten, und dass
b) das Drucksensorelement (8) direkt auf dem Schaltungsträger (2) und auf diesem zudem derart angeordnet ist, dass das Drucksensorelement (8) in dem mit dem Druckmedium (5) druckbeaufschlagten Bereich (12) der Druckführung (4) angeordnet ist, und dass
c) die Auswerteeinheit (10) mit dem Schaltungsträger (2) elektrisch direkt verbunden ist, wobei die Auswerteeinheit (10) wenigstens eine elektrische Kontaktfläche (11) aufweist, welche den Schaltungsträger (2) direkt kontaktiert, wobei die elektrische Kontaktfläche (11) der Auswerteeinheit (10) auf den Schaltungsträger (2) gebondet oder gelötet ist und wobei
d) die elektro-pneumatische Bremseinrichtung eine Magnetventileinrichtung beinhaltet, wobei das elektronische Steuergerät (1) abhängig von dem Drucksignal der Auswerteeinheit (10) die Magnetventileinrichtung elektrisch steuert, und wobei
e) das Gehäuse (14) des Steuergeräts (1) mit einem Ventilblock der Magnetventileinrichtung verbunden ist, und wobei
f) die Druckführung (4) an wenigstens einen Einlass oder einen Auslass wenigstens eines Ventils der Magnetventileinrichtung angeschlossen ist, wobei
g) die Dichtungsmittel (20) eine in einer Ausnehmung (22) in einer zum Schaltungsträger (2) weisenden Oberfläche der Druckführung (4) gehaltene, elastische Formdichtung (20) beinhalten, welche gegen eine gegenüberliegende Oberfläche des Schaltungsträgers (2) vorgespannt ist, wobei die zum Schaltungsträger (2) weisende Oberfläche der Druckführung (4) eine Stirnfläche der Druckführung (4) ist, **dadurch gekennzeichnet, dass**
h) die zum Schaltungsträger (2) weisende Oberfläche der Druckführung (4) zugleich eine Flanschfläche eines an der Druckführung (4) endseitig angeordneten planen Flansches (24) bildet, wobei der plane Flansch (24) an dem planen Schaltungsträger (2) lösbar befestigt ist.

2. Elektro-pneumatische Bremseinrichtung nach Anspruch 1, **dadurch gekennzeichnet, dass** eine Platine der Auswerteeinheit (10) den Schaltungsträger (2) direkt kontaktiert.

3. Elektro-pneumatische Bremseinrichtung nach einem der vorhergehenden Ansprüche, **dadurch gekennzeichnet, dass** die Auswerteeinheit (10) durch wenigstens einen ASIC gebildet wird.

4. Elektro-pneumatische Bremseinrichtung nach einem der vorhergehenden Ansprüche, **dadurch gekennzeichnet, dass** die Auswerteeinheit (10) und das wenigstens eine Drucksensorelement (8) auf verschiedenen, voneinander wegweisenden Seitenflächen des Schaltungsträgers (2) angeordnet sind.

5. Elektro-pneumatische Bremseinrichtung nach einem der vorhergehenden Ansprüche, **dadurch gekennzeichnet, dass** die Auswerteeinheit (10) und das wenigstens eine Drucksensorelement (8) eine Baueinheit (6) bilden.

6. Elektro-pneumatische Bremseinrichtung nach Anspruch 5, **dadurch gekennzeichnet, dass** die Baueinheit (6) auf einem separaten Träger oder in einem eigenen Gehäuse angeordnet ist.

7. Elektro-pneumatische Bremseinrichtung nach einem der vorhergehenden Ansprüche, **dadurch gekennzeichnet, dass** die Kontaktflächen (11) durch ein Dichtungsmittel (25) z.B. Gel, Lackierung, Festdichtung vor Verschmutzung geschützt wird.

8. Elektro-pneumatische Bremseinrichtung nach einem der vorhergehenden Ansprüche, **dadurch gekennzeichnet, dass** die Dichtungsmittel (20) wenigstens eine Klebung zwischen einer Oberfläche der Druckführung (4) und einer Oberfläche des Schaltungsträgers (2) beinhalten.

## Claims

1. Electro-pneumatic braking apparatus for a vehicle, including at least one electronic controller (1) with at least one pressure sensor element (8) and a housing (14) with a pressure guide (4) through which a pressure medium (5) is applied to the pressure sensor element (8), and with an evaluation unit (10) which generates a pressure signal dependent on the pressure in the pressure guide (4) detected by the pressure sensor element (8), and with a planar circuit carrier (2) on which at least one part of a control electronics unit (16) of the controller (1) is arranged, wherein the pressure signal of the evaluation unit (10) is fed into the control electronics unit (16), wherein
a) the pressure guide (4) directly contacts the circuit carrier (2) at least in part and, in the contact region (18) of the pressure guide (4) with the circuit carrier (2), sealing means (20) are arranged which seal a region (12) of the pressure guide (4), pressurised by the pressure medium (5), from the surroundings, and
b) the pressure sensor element (8) is directly arranged on the circuit carrier (2) and is arranged thereon such that the pressure sensor element (8) is arranged in the region (12), pressurised by the pressure medium (5), of the pressure guide (4), and
c) the evaluation unit (10) is directly electrically connected to the circuit carrier (2), wherein the evaluation unit (10) has at least one electrical contact area (11) which makes direct contact with the circuit carrier (2), wherein the electrical contact area (11) of the evaluation unit (10) is bonded or soldered to the circuit carrier (2) and wherein
d) the electro-pneumatic braking apparatus includes a solenoid valve apparatus, wherein the electronic controller (1) electrically controls the solenoid valve apparatus depending on the pressure signal of the evaluation unit (10), and wherein
e) the housing (14) of the controller (1) is connected to a valve block of the solenoid valve apparatus, and wherein
f) the pressure guide (4) is attached to at least one inlet or an outlet of at least one valve of the solenoid valve apparatus, wherein
g) the sealing means (20) include an elastic moulded seal (20) held in a recess (22) in a surface of the pressure guide (4) pointing towards the circuit carrier (2), which seal is pretensioned against an opposite surface of the circuit carrier (2), wherein the surface of the pressure guide (4) pointing towards the circuit carrier (2) is an end face of the pressure guide (4), **characterised in that**
h) the surface of the pressure guide (4) pointing towards the circuit carrier (2) at the same time forms a flange surface of a planar flange (24) arranged at the end of the pressure guide (4), wherein the planar flange (24) is detachably mounted on the planar circuit carrier (2).

2. Electro-pneumatic braking apparatus according to claim 1, **characterised in that** a printed circuit board of the evaluation unit (10) makes direct contact with the circuit carrier (2).

3. Electro-pneumatic braking apparatus according to any one of the preceding claims, **characterised in that** the evaluation unit (10) is formed by at least one ASIC.

4. Electro-pneumatic braking apparatus according to any one of the preceding claims, **characterised in that** the evaluation unit (10) and the at least one pressure sensor element (8) are arranged on different lateral faces of the circuit carrier (2) that point away from one another.

5. Electro-pneumatic braking apparatus according to any one of the preceding claims, **characterised in that** the evaluation unit (10) and the at least one pressure sensor element (8) form a subassembly (6).

6. Electro-pneumatic braking apparatus according to claim 5, **characterised in that** the subassembly (6) is arranged on a separate carrier or in a dedicated housing.

7. Electro-pneumatic braking apparatus according to any one of the preceding claims, **characterised in that** the contact areas (11) are protected from soiling by a sealant (25), e.g. gel, lacquer, solid seal.

8. Electro-pneumatic braking apparatus according to any one of the preceding claims, **characterised in that** the sealing means (20) contain at least one adhesive bond between a surface of the pressure guide (4) and a surface of the circuit carrier (2).

## Revendications

1. Appareil de freinage électro-pneumatique pour un véhicule, contenant au moins un appareil de commande électronique (1) avec au moins un élément de capteur de pression (8) et un boîtier (14) avec un guide de pression (4) à travers lequel l'élément de capteur de pression (8) est mis sous pression avec un milieu de pression (5), ainsi qu'avec une unité d'évaluation (10) qui génère un signal de pression dépendant de la pression détectée par l'élément de capteur de pression (8) dans le guide de pression (4), ainsi qu'avec un support de circuit plan (2) sur lequel au moins une partie d'une électronique de commande (16) de l'appareil de commande (1) est disposée, dans lequel le signal de pression de l'unité d'évaluation (10) est injecté dans l'électronique de commande (16), dans lequel
a) le guide de pression (4) est en contact au moins partiellement direct avec le support de circuit (2) et des moyens d'étanchéité (20) sont disposés dans la zone de contact (18) du guide de pression (4) avec le support de circuit (2), moyens qui assurent l'étanchéité par rapport à l'environnement d'une zone (12) du guide de pression (4) mise sous pression par le milieu de pression (5), et en ce que
b) l'élément de capteur de pression (8) est disposé directement sur le support de circuit (2) et en outre sur celui-ci de sorte que l'élément de capteur de pression (8) soit disposé dans la zone (12) du guide de pression (4) mise sous pression par le milieu de pression (5), et en ce que
c) l'unité d'évaluation (10) est directement connectée électriquement au support de circuit (2), dans lequel l'unité d'évaluation (10) présente au moins une surface de contact électrique (11) qui est en contact direct avec le support de circuit (2), dans lequel la surface de contact électrique (11) de l'unité d'évaluation (10) est soudée ou brasée sur le support de circuit (2), et dans lequel
d) l'appareil de freinage électro-pneumatique contient un appareil d'électrovanne, dans lequel l'appareil de commande électronique (1) commande électriquement l'appareil d'électrovanne en fonction du signal de pression de l'unité d'évaluation (10), et dans lequel
e) le boîtier (14) de l'appareil de commande (1) est connecté à un bloc de vannes de l'appareil d'électrovanne, et dans lequel
f) le guide de pression (4) est raccordé à au moins une entrée ou une sortie d'au moins une vanne de l'appareil d'électrovanne, dans lequel
g) les moyens d'étanchéité (20) contiennent un joint profilé élastique (20) maintenu dans un évidement (22) dans une surface du guide de pression (4) pointant vers le support de circuit (2), joint qui est précontraint contre une surface opposée du support de circuit (2), dans lequel la surface du guide de pression (4) pointant vers le support de circuit (2) est une surface avant du guide de pression (4), **caractérisé en ce que**
h) la surface du guide de pression (4) pointant vers le support de circuit (2) forme en même temps une surface de bride d'une bride plane (24) disposée côté extrémité du guide de pression (4), dans lequel la bride plane (24) est fixée de manière amovible au support de circuit plan (2).

2. Appareil de freinage électro-pneumatique selon la revendication 1, **caractérisé en ce qu'**une platine de l'unité d'évaluation (10) est en contact direct avec le support de circuit (2).

3. Appareil de freinage électro-pneumatique selon l'une quelconque des revendications précédentes, **caractérisé en ce que** l'unité d'évaluation (10) est formée par au moins un ASIC.

4. Appareil de freinage électro-pneumatique selon l'une quelconque des revendications précédentes, **caractérisé en ce que** l'unité d'évaluation (10) et le au moins un élément de capteur de pression (8) sont disposés sur différentes surfaces latérales du support de circuit (2) s'écartant l'une de l'autre.

5. Appareil de freinage électro-pneumatique selon l'une quelconque des revendications précédentes, **caractérisé en ce que** l'unité d'évaluation (10) et le au moins un élément de capteur de pression (8) forment un module (6).

6. Appareil de freinage électro-pneumatique selon la revendication 5, **caractérisé en ce que** le module (6) est disposé sur un support séparé ou dans un propre boîtier.

7. Appareil de freinage électro-pneumatique selon l'une quelconque des revendications précédentes, **caractérisé en ce que** les surfaces de contact (11) sont protégées de l'encrassement par un moyen d'étanchéité (25), par ex. du gel, de la peinture, un joint solide.

8. Appareil de freinage électro-pneumatique selon l'une quelconque des revendications précédentes, **caractérisé en ce que** les moyens d'étanchéité (20) contiennent au moins un collage entre une surface du guide de pression (4) et une surface du support de circuit (2).
